# DEMANDE DE BREVET EUROPEEN

(11) **EP 3 876 288 A1**
(43) Date de publication de la demande: **08.09.2021**
(21) Numéro de dépôt: 21158980.9
(22) Date de dépôt: 24.02.2021
(51) Int. Cl.: H01L 29/06, H01L 29/74, H01L 29/747, H01L 29/861, H01L 21/332, H01L 21/329

(54) **FORMATION D'UN THYRISTOR, TRIAC OU DIODE DE SUPPRESSION DE TENSIONS TRANSITOIRES**

(30) Priorité: 05.03.2020 FR 2002211
(71) Demandeur: STMicroelectronics (Tours) SAS, 37100 Tours (FR)
(72) Inventeur: HAUTTECOEUR, Patrick, 37540 SAINT CYR SUR LOIRE (FR); CARO, Vincent, 37170 CHAMBRAY LES TOURS (FR)
(74) Mandataire: Cabinet Beaumont

(57) **Abrégé**

La présente description concerne un dispositif (13) comprenant :
un substrat (15) semi-conducteur comprenant, en périphérie, une marche (17) ;
une première couche (19) en polysilicium dopé en oxygène, sur et en contact avec une première face du substrat (15) et s'étendant au moins sur les parois et le fond de ladite marche (17) ; et
une deuxième couche (21) en verre, s'étendant sur la première couche (19) et les bords de la première couche (19), ladite deuxième couche (21) en verre formant un bossage (22) entre la marche (17) et une zone centrale du dispositif (13).

## Description

### Domaine technique

La présente description concerne de façon générale les composants électroniques semi-conducteurs et plus particulièrement les thyristors, triacs et diodes de suppression de tensions transitoires (TVS, Transient Voltage Suppressor).

### Technique antérieure

On connaît différentes techniques de fabrication des thyristors.

### Résumé de l'invention

Il existe un besoin d'amélioration des thyristors et de leurs techniques de fabrication. Plus particulièrement, il existe un besoin de diminution des courants de fuite dans les composants électroniques de type thyristors.

Un mode de réalisation pallie tout ou partie des inconvénients des thyristors et de leurs techniques de fabrication.

Un mode de réalisation prévoit un dispositif comprenant :
un substrat semi-conducteur comprenant, en périphérie,
une marche ;
une première couche en polysilicium dopé en oxygène, sur et en contact avec une première face du substrat et s'étendant au moins sur les parois et le fond de ladite marche ; et
une deuxième couche en verre, s'étendant sur la première couche et les bords de la première couche, ladite deuxième couche en verre formant un bossage entre la marche et une zone centrale du dispositif.

Selon un mode de réalisation, la deuxième couche de verre comprend une première sous-couche sur la première couche et alignée avec celle-ci et une deuxième sous-couche s'étendant sur la première sous-couche et recouvrant les bords de la première couche et la première sous-couche.

Selon un mode de réalisation :
la première sous-couche a une épaisseur comprise, au niveau du bossage, entre 5 µm et 30 µm, de préférence comprise entre 10 µm et 20 µm, plus préférentiellement égale à environ 13 µm, encore plus préférentiellement égale à 13 µm ; et/ou
la première sous-couche a une épaisseur comprise, au fond de la marche, entre 20 µm et 60 µm, de préférence comprise entre 30 µm et 40 µm, plus préférentiellement égale à environ 35 µm, encore plus préférentiellement égale à 35 µm.

Selon un mode de réalisation, la deuxième sous-couche a une épaisseur comprise entre 5 µm et 20 µm, de préférence égale à environ 13 µm, plus préférentiellement égale à 13 µm.

Selon un mode de réalisation, la première couche a une épaisseur comprise entre 0,2 µm et 1 µm, de préférence égale à environ 0,5 µm, plus préférentiellement égale à 0,5 µm.

Selon un mode de réalisation, le bossage a une épaisseur comprise entre 10 µm et 50 µm, de préférence comprise entre 10 µm et 35 µm, plus préférentiellement égale à environ 15 µm, par exemple égale à 15 µm.

Selon un mode de réalisation, la marche a une profondeur comprise entre 80 µm et 200 µm, de préférence égale à environ 105 µm, plus préférentiellement égale à 105 µm.

Un mode de réalisation prévoit un composant électronique comportant un dispositif sur chaque face du substrat de sorte à former un thyristor, un triac ou une diode de suppression de tensions transitoires.

Un mode de réalisation prévoit un procédé de fabrication du dispositif, comportant, entre autres, les étapes suivantes :
former, en périphérie du substrat, la marche ;
former la première couche en polysilicium dopé en oxygène, sur et en contact avec la première face du substrat, la première couche s'étendant au moins sur les parois et le fond de ladite marche ; et
former la deuxième couche en verre, s'étendant sur la première couche et les bords de la première couche, de façon à former, entre la marche et la partie centrale du dispositif, le bossage.

Selon un mode de réalisation, la formation de la deuxième couche de verre comporte les étapes suivantes :
former, sur la première couche, la première sous-couche en verre ;
réaliser une première gravure humide de la première couche et de la première sous-couche selon le motif d'un premier masque d'une résine réalisé par photolithographie ;
former la deuxième sous-couche en verre sur la première sous-couche de sorte que la deuxième sous-couche recouvre la première sous-couche et les bords de la première couche et de la première sous-couche, de façon à réaliser le bossage à la périphérie intérieure de la marche ; et
réaliser une deuxième gravure humide de la deuxième sous-couche selon le motif d'un deuxième masque d'une résine réalisé par photolithographie.

Selon un mode de réalisation, la première gravure est réalisée dans un bain, composé d'environ 59 % de fluorure d'ammonium, d'environ 6 % de fluorure d'hydrogène et d'environ 35 % de peroxyde d'hydrogène.

Selon un mode de réalisation, la deuxième gravure est réalisée dans un bain, composé d'environ 50 % de fluorure d'hydrogène et d'environ 50% d'acide chlorhydrique.

Selon un mode de réalisation, les première et deuxième gravures sont réalisées dans des bains dont la température est comprise entre dix-huit degrés Celsius et trente degrés Celsius, de préférence comprise entre vingt degrés Celsius et vingt-cinq degrés Celsius, plus préférentiellement égale à environ vingt-deux degrés Celsius, encore plus préférentiellement égale à vingt-deux degrés Celsius.

Selon un mode de réalisation, la première gravure a une durée comprise entre trente minutes et soixante minutes, de préférence comprise entre quarante minutes et cinquante minutes, plus préférentiellement égale à environ quarante six minutes, encore plus préférentiellement égale à quarante six minutes.

Selon un mode de réalisation, la deuxième gravure a une durée comprise entre une minute et deux minutes, de préférence comprise entre une minute quinze secondes et une minute quarante secondes, plus préférentiellement égale à environ une minute trente secondes, encore plus préférentiellement égale à une minute trente secondes.

Selon un mode de réalisation, la première couche est déposée par dépôt chimique en phase vapeur à pression sous-atmosphérique ou par dépôt chimique en phase vapeur assisté par plasma.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, par une vue en coupe, partielle et schématique, un mode de réalisation d'un composant électronique de type thyristor ;
la figure 2 représente, par une vue de dessus, partielle et schématique, une plaquette de composants électroniques ;
la figure 3 représente, par une vue en coupe, partielle et schématique, une étape d'un mode de mise en oeuvre d'un procédé de fabrication du composant illustré en figure 1 ;
la figure 4 représente, par une vue en coupe, partielle et schématique, une autre étape d'un mode de mise en oeuvre d'un procédé de fabrication du composant illustré en figure 1 ;
la figure 5 représente, par une vue en coupe, partielle et schématique, encore une autre étape d'un mode de mise en oeuvre d'un procédé de fabrication du composant illustré en figure 1 ;
la figure 6 représente, par une vue en coupe, partielle et schématique, encore une autre étape d'un mode de mise en oeuvre d'un procédé de fabrication du composant illustré en figure 1 ;
la figure 7 représente, par une vue en coupe, partielle et schématique, encore une autre étape d'un mode de mise en oeuvre d'un procédé de fabrication du composant illustré en figure 1 ;
la figure 8 représente, par une vue en coupe, partielle et schématique, encore une autre étape d'un mode de mise en oeuvre d'un procédé de fabrication du composant illustré en figure 1 ;
la figure 9 représente, par une vue en coupe, partielle et schématique, encore une autre étape d'un mode de mise en oeuvre d'un procédé de fabrication du composant illustré en figure 1 ; et
la figure 10 représente, par une vue en coupe, partielle et schématique, encore une autre étape d'un mode de mise en oeuvre d'un procédé de fabrication du composant illustré en figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les premières étapes de la fabrication d'un thyristor n'ont pas été détaillées, seules les étapes de protection contre les fuites de courant ont été décrites.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

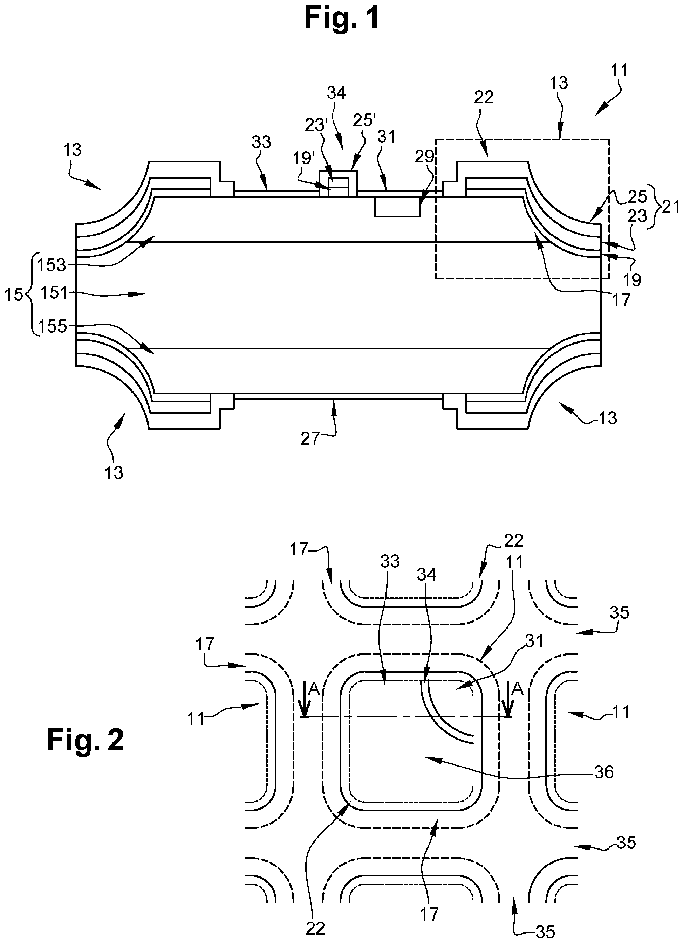

La figure 1 représente, par une vue en coupe, partielle et schématique, un mode de réalisation d'un composant électronique de type thyristor.

Plus particulièrement, la figure 1 illustre un composant 11 électronique à haute tension, par exemple un thyristor ayant une tension d'amorçage supérieure à environ 1 200 V.

Dans la suite de la description, on considère la face supérieure de la structure, dans l'orientation de la figure 1, comme étant la face avant et la face inférieure de la structure, dans l'orientation de la figure 1, comme étant la face arrière.

Le composant électronique 11 illustré en figure 1 a, par exemple, en vue de dessus, la forme d'un squircle (carré dont les angles sont arrondis), d'un rectangle dont les angles sont arrondis ou d'un cercle.

Le composant 11 comprend, par exemple, sur chacun des bords de ses faces supérieure et inferieure, un premier empilement ou dispositif 13. Plus particulièrement, le composant 11 comprend un empilement 13 sur le ou les bords de sa face inférieure et un empilement 13 identique sur le ou les bords de sa face supérieure.

l'empilement ou dispositif 13 comprend :
un substrat 15 semiconducteur comprenant, en périphérie, une marche 17 ;
une première couche 19 en polysilicium dopé en oxygène (SIPOS, Semi-Insulating Polycrystalline Silicon), sur et en contact avec une première face du substrat 15 et s'étendant au moins sur les parois et le fond de la marche 17 ; et
une deuxième couche en verre 21, s'étendant sur la première couche 19 et les bords de la première couche 19 et formant, en périphérie intérieure de la marche 17, une surépaisseur ou bossage 22.

Le SIPOS correspond à un polysilicium dopé en oxygène, c'est-à-dire un polysilicium qui possède, généralement, une concentration en oxygène supérieure à environ 10 %. La concentration en oxygène du SIPOS dans la présente description est, de préférence, comprise entre 20 % et 60 % et est, plus préférentiellement, de l'ordre de 40 %.

La deuxième couche en verre 21 comprend, par exemple, deux sous-couches :
une première sous-couche 23, sur et en contact avec la première couche 19 et alignée avec celle-ci ; et
une deuxième sous-couche 25 s'étendant sur la première sous-couche 23 et recouvrant les bords de la première couche 19 et de la première sous-couche 23, la deuxième sous-couche 25 étant en contact avec la première sous-couche 23.

Selon le mode de réalisation illustré en figure 1, la deuxième sous-couche 25 recouvre, en outre, une partie du substrat 15 non recouvert par la première couche 19.

Dans le cas d'un composant possédant un empilement 13 sur ses deux faces, le substrat 15 est commun aux deux empilements.

Dans le mode de réalisation de la figure 1, le composant 11 comprend en outre :
une première électrode 27 sur la face arrière du substrat 15, au centre du composant 11, de sorte que la première électrode 27 soit entourée par la deuxième sous-couche 25 ;
une zone 29 enterrée, côté face supérieure du substrat 15 et affleurant cette même face, la zone 29 n'étant pas centrée sur la face supérieure, et étant, de préférence, située plus près de l'empilement 13 que du centre de la structure, par exemple, à droite (dans l'orientation de la figure 1) sur la face supérieure du substrat 15 ;
une deuxième électrode 31, sur la face avant du substrat et à l'aplomb de la zone 29, ladite électrode 31 se prolongeant à droite (dans l'orientation de la figure 1) vers la deuxième sous-couche 25 de l'empilement 13 et jusqu'à celle-ci ;
une troisième électrode 33 sur la face avant du substrat 15, sur une partie de ladite face du substrat 15 non recouverte par la deuxième électrode 31, ladite électrode 33 étant, par exemple, à gauche (dans l'orientation de la figure 1) sur la face supérieure du substrat 15 et s'étendant à gauche (dans l'orientation de la figure 1) jusqu'à la deuxième sous-couche 25, l'électrode 33 et l'électrode 31 ne se touchant pas ; et
un deuxième empilement 34 entre la deuxième électrode 31 et la troisième électrode 33.

Selon le mode de réalisation illustré en figure 1, le substrat 15 comprend une première partie 151, centrale, d'un matériau d'un premier type de conductivité n. Le substrat 15 comprend une deuxième partie 153, située sur la face supérieure de la première partie 151 du substrat 15, d'un matériau d'un deuxième type de conductivité p. Le substrat 15 comprend, en outre, une troisième partie 155, située sur la face inférieure du substrat 15, d'un matériau du deuxième type de conductivité p. Les matériaux des deuxième 153 et troisième parties 155 du substrat 15 peuvent être de composition sensiblement identique, identique ou de compositions différentes.

La zone 29 est, par exemple, en un matériau du premier type de conductivité n fortement dopé (plus fortement dopé que la partie 153).

L'empilement 34 comprend :
une partie 19' de la première couche 19 sur et en contact avec la face supérieure du substrat 15, les bords latéraux de la partie 19' de la première couche 19 n'étant pas en contact avec les électrodes 31 et 33 ;
une partie 23' de la première sous-couche 23 sur et en contact avec la face supérieure de la partie 19' de la première couche 19 ; et
une partie 25' de la deuxième sous-couche 25 sur et en contact avec la face supérieure de la partie 23' de la première sous-couche 23, la partie 25' de la deuxième sous-couche 25 recouvrant les bords latéraux de la partie 23' de la première sous-couche 23 et les bords latéraux de la partie 19' de la première couche 19.

Le composant 11 est ainsi constitué de quatre couches, 155, 151, 153 et 29 alternativement dopées n et p, qui définissent un thyristor.

L'anode du thyristor est l'électrode 27, en contact avec la partie 155 du substrat 15. La cathode du thyristor est l'électrode 31 en contact avec la zone 29 et la gâchette est l'électrode 33, en contact avec la partie 153 du substrat 15.

La figure 2 représente, par une vue de dessus, partielle et schématique, une plaquette de composants électroniques.

Plus particulièrement, la figure 2 représente une plaquette (wafer) ou partie de plaquette sur laquelle une pluralité de composants 11 a été réalisée. La figure 1 est une vue en coupe, selon le plan de coupe AA de la figure 2.

Les composants 11 sont, généralement, fabriqués par plaquettes. C'est-à-dire qu'une pluralité de composants 11 est fabriquée simultanément sur une même plaquette semiconductrice, par exemple, en silicium. Les composants 11 sont, à la fin du processus de fabrication, individualisés.

La figure 2 représente plusieurs composants 11 (un composant entier et huit composants visibles partiellement) possédant chacun une partie périphérique et une partie centrale 36. La partie périphérique de chaque composant 11 est composée de l'empilement 13 qui comprend une marche 17 et un bossage 22 en lisère de la dite marche 17.

La face avant de la partie centrale 36 de chaque composant 11 est constituée, comme représenté en figure 2, de la deuxième électrode 31 sur un des coins ou bords du composant 11 et de la troisième électrode 33. L'électrode 31 et l'électrode 33 sont séparées par l'empilement 34 qui s'étend d'un bord du composant 11 à un autre bord de ce même composant 11. L'empilement 34 prend, par exemple, la forme d'un arc de cercle.

Les différents composants 11 sont individualisés par découpe, par exemple par sciage, selon des chemins de découpe 35.

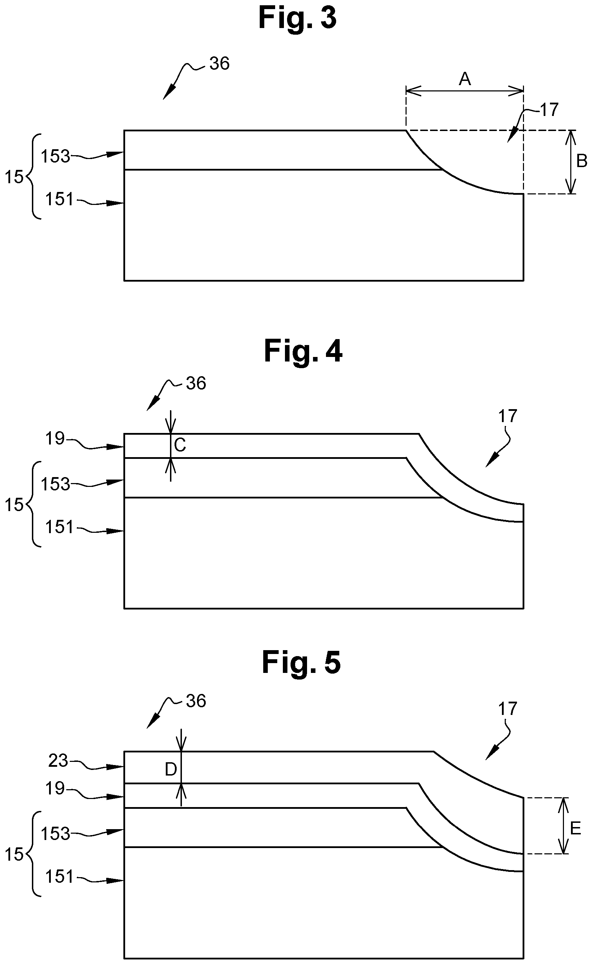

Les figures 3 à 10 illustrent, de façon schématique et partielle, des étapes successives d'un mode de mise en oeuvre d'un procédé de fabrication du composant électronique 11 illustré en figure 1. Plus particulièrement, les figures 3 à 10 illustrent, de façon schématique et partielle, des étapes successives d'un mode de mise en oeuvre d'un procédé de fabrication de l'empilement 13.

Pour simplifier la description, sauf précision contraire, on assimile une étape de fabrication à la structure obtenue à l'issue de cette étape.

La figure 3 représente, par une vue en coupe, partielle et schématique, une étape d'un mode de mise en oeuvre d'un procédé de fabrication du composant illustré en figure 1.

Plus particulièrement, la figure 3 représente une structure, comprenant le substrat 15 dans lequel la marche 17 a été formée. La marche 17 a une largeur A et une profondeur B.

Les marches 17 sont, par exemple, réalisées, au niveau de la plaquette, par sciage partiel ou par gravure humide, non traversant selon un motif de quadrillage entre les futurs thyristors. Ces traits de coupe forment des sillons qui définissent ultérieurement les chemins de découpe 35.

Les chemins de découpe 35 d'individualisation des composants 11 (figure 2) sont, de préférence, réalisés avec une lame plus fine que la lame permettant la formation des sillons des marches 17.

La largeur A de la marche est, par exemple, comprise entre 200 µm et 400 µm, de préférence comprise entre 250 µm et 350 µm. La largeur A est plus préférentiellement égale à 300 µm.

La profondeur B de la marche 17 est, par exemple, comprise entre 80 µm et 200 µm, de préférence égale à environ 105 µm. La profondeur B est, plus préférentiellement égale à 105 µm.

Ainsi, avec une plaquette ayant une épaisseur, par exemple, comprise entre 300 µm et 400 µm, l'épaisseur résiduelle des bords des substrats des composants 11 est, par exemple, comprise entre 90 µm et 200 µm.

La figure 4 représente, par une vue en coupe, partielle et schématique, une autre étape d'un mode de mise en oeuvre d'un procédé de fabrication du composant illustré en figure 1.

Plus particulièrement, la figure 4 illustre une étape de dépôt de la première couche 19 en SIPOS sur la face avant de la structure illustrée en figure 3.

La couche 19 est déposée sur l'ensemble de la structure (pleine plaque), c'est-à-dire qu'elle est déposée sur la face supérieure du substrat 15 et sur les bords et le fond de la marche 17. La couche 19 a une épaisseur C sensiblement constante sur l'ensemble de sa surface.

L'épaisseur C de la première couche 19 est, par exemple, comprise entre 0,2 µm et 1 µm, de préférence égale à environ 0,5 µm. L'épaisseur C est plus préférentiellement égale à 0,5 µm.

Le dépôt de la couche 19 est effectué par dépôt chimique en phase vapeur à pression sous-atmosphérique (LPCVD, Low-Pressure Chemical Vapor Deposition) ou par dépôt chimique assisté par plasma (PECVD, Plasma Enhanced Chemical Vapor Deposition).

La figure 5 représente, par une vue en coupe, partielle et schématique, encore une autre étape d'un mode de mise en oeuvre d'un procédé de fabrication du composant illustré en figure 1.

Plus particulièrement, la figure 5 illustre une étape de dépôt de la première sous-couche 23 de la deuxième couche 21 (figure 1) sur la face avant de la structure obtenue à l'issue des étapes des figures 3 et 4.

La sous-couche 23 est déposée pleine plaque. Elle recouvre ainsi l'ensemble de la couche 19, dans la marche 17 et au droit de la marche 17, au niveau de la partie centrale 36. La sous-couche 23 est, par exemple, déposée par centrifugation (spin-coating) sur la face avant de la couche 19. Il en découle que l'épaisseur de de la sous-couche 23 n'est pas constante mais est plus importante au fond des marches 17 (dans les sillons de la plaquette entre les composants 11) qu'en leur sommet et dans les parties centrales 36.

L'épaisseur D, dans la partie centrale 36, est donc inférieure à l'épaisseur E au fond de la marche 17.

L'épaisseur D de la première sous-couche 23, dans la partie centrale 36, est, par exemple, comprise entre 5 µm et 30 µm, de préférence comprise entre 10 µm et 20 µm. L'épaisseur D est plus préférentiellement égale à environ 13 µm, encore plus préférentiellement égale à 13 µm.

L'épaisseur E de la première sous-couche 23, au fond de la marche 17 est, par exemple, comprise entre 20 µm et 60 µm, de préférence comprise entre 30 µm et 40 µm. L'épaisseur E, est plus préférentiellement égale à 35 µm, encore plus préférentiellement égale à 35 µm.

La différence d'épaisseur entre la partie 36 et le fond de la marche 17 permet d'atténuer l'angle (d'ouvrir l'angle) présent au sommet de la marche 17.

La sous-couche 23 est, par exemple, en verre.

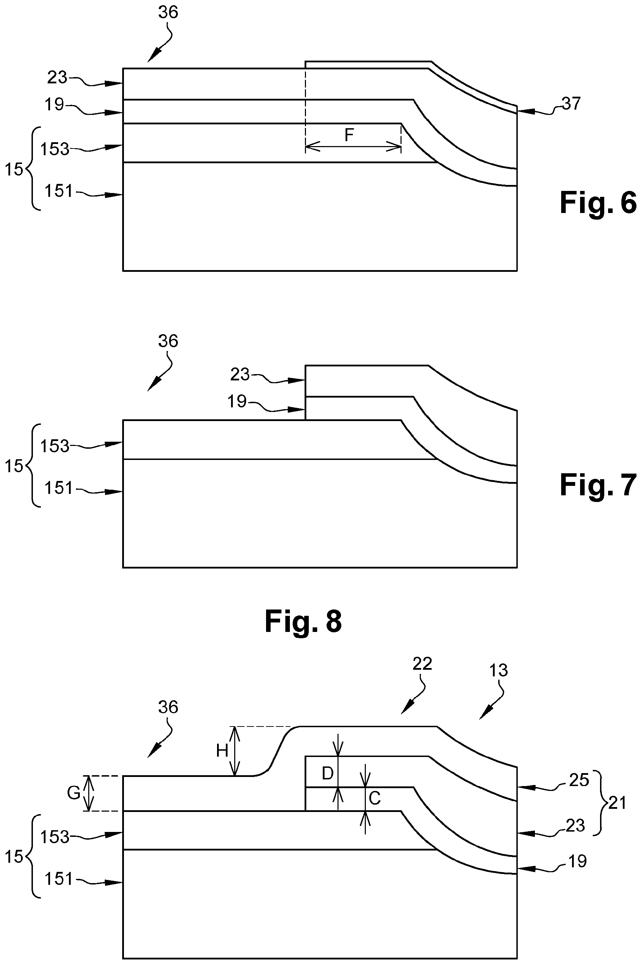

La figure 6 représente, par une vue en coupe, partielle et schématique, encore une autre étape d'un mode de mise en oeuvre d'un procédé de fabrication du composant illustré en figure 1.

Plus particulièrement, la figure 6 illustre une étape de dépôt et de photolithographie d'une troisième couche 37 d'une première résine sur la face avant de la structure obtenue à l'issue des étapes des figures 3 à 5.

Dans le présent mode de réalisation, on vient recouvrir la première sous-couche 23 par la troisième couche 37. La troisième couche 37 est déposée par centrifugation (spin-coating) de sorte à recouvrir la première sous-couche 23.

La couche 37 subit, ensuite, une photolithographie, c'est-à-dire que la couche 37 est exposée aux UV au travers d'un premier masque puis elle est développée dans un solvant.

Selon un mode de réalisation, la première résine est une résine positive, c'est-à-dire que la partie de la résine exposée aux UV devient soluble dans un solvant.

Selon un autre mode de réalisation, la première résine est une résine négative, c'est-à-dire que la partie de la résine exposée aux UV devient insoluble dans un solvant.

La couche 37 s'étend, à l'issue de l'étape de lithographie, dans les marches 17 et, dans la direction de la partie centrale 36, sur une distance F. La distance F correspond à la distance entre le sommet de la marche 17 à la surface du substrat et le bord latéral, dirigé vers la partie centrale 36, de la couche 37.

La distance F est, par exemple, comprise entre 5 µm et 15 µm, de préférence comprise entre 6 µm et 14 µm. La distance F est plus préférentiellement égale à 10 µm.

La couche 37 est, dans l'étape qui suit, utilisée comme masque pour une première gravure des couches sous-jacentes, c'est-à-dire des couches 19 et 23.

La figure 7 représente, par une vue en coupe, partielle et schématique, encore une autre étape d'un mode de mise en oeuvre d'un procédé de fabrication du composant illustré en figure 1.

Plus particulièrement, la figure 7 illustre une étape de gravure humide de la première couche 19 et de la première sous-couche 23 à partir de la structure obtenue à l'issue des étapes des figures 3 à 6.

On vient retirer par gravure les parties des couches 23 et 19 qui ne sont pas surmontées par la couche 37.

La première gravure est réalisée dans un bain, composé d'environ 59 % (volumique) de fluorure d'ammonium (soit environ dix volumes), d'environ 6 % de fluorure d'hydrogène (soit environ un volume) et d'environ 35 % de peroxyde d'hydrogène (soit environ six volumes).

La première gravure est réalisée dans un bain dont la température est comprise entre dix-huit degrés Celsius et trente degrés Celsius, de préférence comprise entre vingt degrés Celsius et vingt-cinq degrés Celsius. La première gravure est réalisée dans un bain dont la température est, par exemple, égale à vingt-deux degrés Celsius.

La première gravure a une durée comprise entre trente minutes et soixante minutes, de préférence comprise entre quarante minutes et cinquante minutes. La durée de la première gravure est plus préférentiellement égale à environ quarante six minutes, encore plus préférentiellement égale à quarante six minutes.

Lors de cette étape, la couche 37 est éliminée. A l'issue de l'étape illustrée en figure 7, la structure ne comprend donc plus de couche 37.

La figure 8 représente, par une vue en coupe, partielle et schématique, encore une autre étape d'un mode de mise en oeuvre d'un procédé de fabrication du composant illustré en figure 1.

Plus particulièrement, la figure 8 illustre une étape de dépôt de la deuxième sous-couche 25 de la deuxième couche 21 sur la face avant de la structure obtenue à l'issue des étapes des figures 3 à 7. La deuxième sous-couche 25 permet de combler des éventuels trous qui se sont formés dans la première sous-couche 23 lors du dépôt de celle-ci. En outre, la deuxième sous-couche 25 permet, avec la première sous-couche 23 d'encapsuler la couche 19.

On vient, au cours de cette étape, déposer la sous-couche 25 pleine plaque, et ainsi recouvrir la face avant de la sous-couche 23 et une partie du substrat 15 non recouverte par la couche 19. La sous-couche 25 est, par exemple, déposée par centrifugation sur la face avant de la structure. La sous-couche 25, similairement à sous-couche 23, n'a pas une épaisseur constante mais a une épaisseur plus importante au fond des marches 17 qu'au sommet des marches 17. Ce phénomène est toutefois moindre dans le cas de la sous-couche 25 car l'épaisseur moyenne de la sous-couche 25 est inférieure à l'épaisseur de la sous-couche 23.

La sous-couche 25 est déposée avec une épaisseur G, mesurée sur la partie du substrat non recouverte par la couche 19, c'est-à-dire dans la partie centrale 36. La sous-couche 25 forme à l'aplomb de la sous-couche 23, un bossage 22 dont la hauteur H dépend des épaisseurs C, D et G respectives des couches 19, 23 et 25.

L'épaisseur G de la deuxième sous-couche 25 est comprise entre 5 µm et 20 µm. L'épaisseur G est, de préférence égale à environ 13 µm, plus préférentiellement égale à 13 µm.

L'épaisseur H du bossage 22 est comprise entre 10 µm et 50 µm, de préférence comprise entre 10 µm et 35 µm. L'épaisseur H est plus préférentiellement égale à environ 15 µm, encore plus préférentiellement égale à 15 µm.

La deuxième sous-couche 25 est, par exemple, en verre.

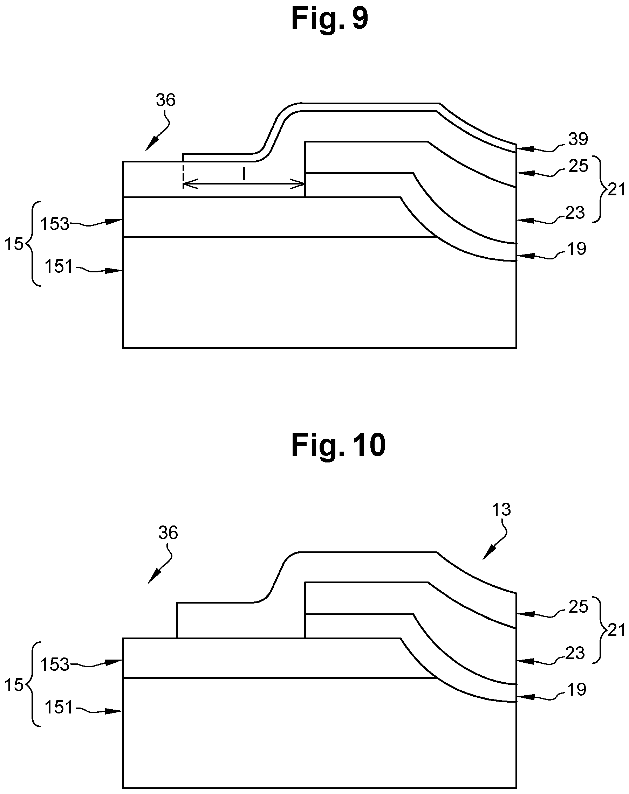

La figure 9 représente, par une vue en coupe, partielle et schématique, encore une autre étape d'un mode de mise en oeuvre d'un procédé de fabrication du composant illustré en figure 1.

Plus particulièrement, la figure 9 illustre une étape de dépôt d'une quatrième couche 39 d'une deuxième résine sur la face avant de la structure obtenue à l'issue des étapes des figures 3 à 8, suivie d'une photolithographie de celle-ci.

On vient, au cours de cette étape, déposer la quatrième couche 39 pleine plaque, et ainsi recouvrir la face avant de la sous-couche 25. La couche 39 est, par exemple, déposée par centrifugation sur la face avant de la structure.

La couche 39 subit, ensuite, une photolithographie, c'est-à-dire que la couche 39 est exposée aux UV au travers d'un deuxième masque puis elle est développée dans un solvant.

Selon un mode de réalisation, la deuxième résine est une résine positive.

Selon un autre mode de réalisation, la deuxième résine est une résine négative.

La couche 39 s'étend, à l'issue de l'étape de lithographie, sur les couches 19 et 23 et, au-delà des couches 19 et 23, vers la partie centrale 36 du composant 11 sur une distance I. La distance I correspond à la distance entre le bord latéral de la couche 39 et le bord latéral des couches 19 et 23.

La distance I est comprise entre 5 µm et 20 µm, de préférence égale à environ 10 µm. La distance I est plus préférentiellement égale à 10 µm.

A la fin de l'étape de photolithographie, il n'y a plus de couche 39 dans la partie centrale 36. La couche 39 est, dans l'étape qui suit, utilisée comme masque pour une deuxième gravure de la couche sous-jacente, c'est-à-dire de la sous-couche 25.

La figure 10 représente, par une vue en coupe, partielle et schématique, encore une autre étape d'un mode de mise en oeuvre d'un procédé de fabrication du composant illustré en figure 1.

Plus particulièrement, la figure 10 illustre une étape de gravure de la deuxième sous-couche 25 à partir de la structure obtenue à l'issue des étapes des figures 3 à 9.

On vient retirer par gravure les parties de la sous-couche 25 qui ne sont pas surmontées par la couche 39.

La deuxième gravure est réalisée dans un bain composé d'environ 50 % (volumique) de fluorure d'hydrogène et d'environ 50 % d'acide chlorhydrique.

La température du bain de la deuxième gravure est sensiblement identique à la température du bain de la première gravure.

La deuxième gravure a une durée comprise entre une minute et deux minutes, de préférence comprise entre une minute quinze secondes et une minute quarante secondes. La durée de la deuxième gravure est plus préférentiellement égale à environ une minute trente secondes, encore plus préférentiellement égale à une minute trente secondes.

Lors de cette étape, la couche 39 est également gravée sur toute son épaisseur. A l'issue de l'étape illustrée en figure 10, la structure ne comprend plus de couche 39.

On aurait pu penser déposer la couche de SIPOS puis effectuer la gravure de cette même couche avant de déposer les deux couches de verre et les graver simultanément. Cela présenterait toutefois l'inconvénient de nécessiter deux étapes de photolithographie préalables à la gravure du SIPOS à cause de la profondeur des marches 17. La profondeur de la marche 17, dans la présente description, est atténuée par le dépôt de la sous-couche 23 qui a un effet de planarisation partielle.

Un avantage des modes de réalisation décrits est qu'ils permettent d'intégrer une couche de SIPOS dans la structure d'un thyristor, ce qui permet de diminuer les courants de fuite.

Un autre avantage des modes de réalisation et des modes de mise en oeuvre décrits est qu'ils permettent de former des dispositifs dont les couches de SIPOS et de verre sont continues, sans risque de trous, au niveau de l'angle formé au sommet de chaque marche.

Un autre avantage des modes de réalisation décrits est qu'ils permettent de s'affranchir d'une étape de photolithographie et donc d'une part de diminuer les coûts de fabrication du thyristor considéré, et d'autre part de gagner en précision pour l'alignement des différentes couches.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. Les modes de réalisations décrits ne se limitent pas aux exemples de dimensions et de matériaux mentionnées ci-dessus.

Enfin, la mise en oeuvre pratique des modes de réalisation et variantes décrits est à la portée de l'homme du métier à partir des indications fonctionnelles données ci-dessus.

## Revendications

1. Dispositif (13) comprenant :
un substrat (15) semi-conducteur comprenant, en périphérie, une marche (17) ;
une première couche (19) en polysilicium dopé en oxygène, sur et en contact avec une première face du substrat (15) et s'étendant au moins sur les parois et le fond de ladite marche (17) ; et
une deuxième couche (21) en verre, s'étendant sur la première couche (19) et les bords de la première couche (19), ladite deuxième couche (21) en verre formant un bossage (22) entre la marche (17) et une zone centrale (36) du dispositif.

2. Dispositif selon la revendication 1, dans lequel la deuxième couche (21) de verre comprend une première sous-couche (23) sur la première couche (19) et alignée avec celle-ci, et une deuxième sous-couche (25) s'étendant sur la première sous-couche (23) et recouvrant les bords de la première couche (19) et la première sous-couche (23).

3. Dispositif selon la revendication 2, dans lequel :
la première sous-couche (23) a une épaisseur (D) comprise, au niveau du bossage, entre 5 µm et 30 µm, de préférence comprise entre 10 µm et 20 µm, plus préférentiellement égale à environ 13 µm, encore plus préférentiellement égale à 13 µm ; et/ou
la première sous-couche (23) a une épaisseur (E) comprise, au fond de la marche (17), entre 20 µm et 60 µm, de préférence comprise entre 30 µm et 40 µm, plus préférentiellement égale à environ 35 µm, encore plus préférentiellement égale à 35 µm.

4. Dispositif selon la revendication 2 ou 3, dans lequel la deuxième sous-couche (25) a une épaisseur (G) comprise entre 5 µm et 20 µm, de préférence égale à environ 13 µm, plus préférentiellement égale à 13 µm.

5. Dispositif selon l'une quelconque des revendications 1 à 4, dans lequel la première couche (19) a une épaisseur (C) comprise entre 0,2 µm et 1 µm, de préférence égale à environ 0,5 µm, plus préférentiellement égale à 0,5 µm.

6. Dispositif selon l'une quelconque des revendications 1 à 5, dans lequel le bossage (22) a une épaisseur (H) comprise entre 10 µm et 50 µm, de préférence comprise entre 10 µm et 35 µm, plus préférentiellement égale à environ 15 µm, par exemple égale à 15 µm.

7. Dispositif selon l'une quelconque des revendications 1 à 6, dans lequel la marche (17) a une profondeur (B) comprise entre 80 µm et 200 µm, de préférence égale à environ 105 µm, plus préférentiellement égale à 105 µm.

8. Composant électronique (11) comportant un dispositif (13) selon l'une quelconque des revendications 1 à 7 sur chaque face du substrat (15) de sorte à former un thyristor, un triac ou une diode de suppression de tensions transitoires.

9. Procédé de fabrication du dispositif (13) selon l'une quelconque des revendications 1 à 7, comportant, entre autres, les étapes suivantes :
former, en périphérie du substrat (15), la marche (17) ;
former la première couche (19) en polysilicium dopé en oxygène, sur et en contact avec la première face du substrat (15), la première couche (19) s'étendant au moins sur les parois et le fond de ladite marche (17) ; et
former la deuxième couche (21) en verre, s'étendant sur la première couche (19) et les bords de la première couche (19), de façon à former, entre la marche (17) et la partie centrale (36) du dispositif (13), le bossage (22) .

10. Procédé selon la revendication 9 dans son rattachement à la revendication 2, dans lequel la formation de la deuxième couche (21) de verre comporte les étapes suivantes :
former, sur la première couche (19), la première sous-couche (23) en verre ;
réaliser une première gravure humide de la première couche (19) et de la première sous-couche (23) selon le motif d'un premier masque d'une résine réalisé par photolithographie ;
former la deuxième sous-couche (25) en verre sur la première sous-couche (23) de sorte que la deuxième sous-couche (25) recouvre la première sous-couche (23) et les bords de la première couche (19) et de la première sous-couche (23), de façon à réaliser le bossage (22) à la périphérie intérieure de la marche (17) ; et
réaliser une deuxième gravure humide de la deuxième sous-couche (25) selon le motif d'un deuxième masque d'une résine réalisé par photolithographie.

11. Procédé selon la revendication 10, dans lequel la première gravure est réalisée dans un bain, composé d'environ 59 % de fluorure d'ammonium, d'environ 6 % de fluorure d'hydrogène et d'environ 35 % de peroxyde d'hydrogène.

12. Procédé selon la revendication 10 ou 11, dans lequel la deuxième gravure est réalisée dans un bain, composé d'environ 50 % de fluorure d'hydrogène et d'environ 50% d'acide chlorhydrique.

13. Procédé selon l'une quelconque des revendications 10 à 12, dans lequel les première et deuxième gravures sont réalisées dans des bains dont la température est comprise entre dix-huit degrés Celsius et trente degrés Celsius, de préférence comprise entre vingt degrés Celsius et vingt-cinq degrés Celsius, plus préférentiellement égale à environ vingt-deux degrés Celsius, encore plus préférentiellement égale à vingt-deux degrés Celsius.

14. Procédé selon l'une quelconque des revendications 10 à 13, dans lequel la première gravure a une durée comprise entre trente minutes et soixante minutes, de préférence comprise entre quarante minutes et cinquante minutes, plus préférentiellement égale à environ quarante six minutes, encore plus préférentiellement égale à quarante six minutes.

15. Procédé selon l'une quelconque des revendications 10 à 14, dans lequel la deuxième gravure a une durée comprise entre une minute et deux minutes, de préférence comprise entre une minute quinze secondes et une minute quarante secondes, plus préférentiellement égale à environ une minute trente secondes, encore plus préférentiellement égale à une minute trente secondes.

16. Procédé selon l'une quelconque des revendications 9 à 15, dans lequel la première couche (19) est déposée par dépôt chimique en phase vapeur à pression sous-atmosphérique ou par dépôt chimique en phase vapeur assisté par plasma.
